Europäisches Patentamt

European Patent Office

Office européen des brevets

(11) Veröffentlichungsnummer: **0 398 040**
**A2**

## EUROPÄISCHE PATENTANMELDUNG

(21) Anmeldenummer: **90107680.2**

(22) Anmeldetag: **23.04.90**

(51) Int. Cl.5: **H03K 12/00, H03K 19/0175**

(30) Priorität: **11.05.89 DE 3915452**

(43) Veröffentlichungstag der Anmeldung:
**22.11.90 Patentblatt 90/47**

(84) Benannte Vertragsstaaten:
**AT BE CH DE DK ES FR GB GR IT LI NL SE**

(71) Anmelder: **Siemens Aktiengesellschaft**
**Wittelsbacherplatz 2**
**D-8000 München 2(DE)**

(72) Erfinder: **Sarközi, Imre, Dipl.-Ing.**
**Karl-Witthalm-Strasse 42**
**D-8000 München 70(DE)**

(54) **Anordnung mit einem Oszillator mit ECL-Pegel-Ausgang und mit einem ECL-TTL-Umsetzer.**

(57) Mit diskreten Elementen aufgebauten Quarzos-zillatoren geben ECL-Pegel ab. TTL-Pegel werden über ECL-TTL-Umsetzer-Bausteine abgeleitet. Es wird eine Verminderung des Leistungsaufwands an-gestrebt.

Der Quarzoszillator (I) wird ausgangsseitig mit einer Emitterfolgerstufe (1) ausgerüstet, die einen pnp-Transistor (4) einen an +5V (2) angeschlosse-nen Emitterwiderstand (3) und einen geerdeten Kol-lektorwiderstand (5) enthält. Der Emitter ist mit ei-nem ECL-Pegel-Ausgang (6) und der Kollektor mit einem Kollektoranschluß (7) verbunden. Ein ECL-TTL-Umsetzer (II) enthält einen pnp-Transistor (12), einen mit dem ECL-Pegel-Ausgang (6) über einen ersten Schalter (16) verbundenen Emitterwidertand (11), einen geerdeten Kollektorwiderstand 913), ei-nen die Basis des Transistors (12) mit dem Kollek-toranschluß (7) verbindenden Kondensator (8) und einen Basis-Vorspannungserzeuger (10) mit Basis-Vorwiderstand (9). Der Kollektor des Transistors (12) dient als TTL-Pegel-Ausgang (14). Ein zweiter Schal-ter (17) kann den Kollektorwiderstand (5) kurzschlie-ßen. Eine Schaltersteuerung (18) schließt und öffnet beide Schalter (16, 17) gegensinnig.

Die Anordnung ist für Anwendung mit einfacher (+5V, Masse) Versorgungsspannung in Digitalsignal-Multiplexgeräten geeignet.

FIG 1

## Anordnung mit einem Oszillator mit ECL-Pegel-Ausgang und mit einem ECL-TTL-Umsetzer.

Die Erfindung bezieht sich auf eine Anordnung mit einem Oszillator, der eine ausgangsseitige Ermitterfolgerstufe enthält, deren Emitterwiderstand mit einem +5V-Betriebsspannungsanschluß und deren Emitter mit einem ECL-Pegel-Ausgang verbunden ist und mit einem ECL-TTL-Umsetzer.

In Digitalsignal-Multiplexgeräten werden für die Erzeugung von Takten diskret aufgebaute Quarzoszillatoren sowie spannungsgesteuerte Quarzoszillatoren eingesetzt, deren Ausgangspegel entweder der Ansteuerung von ECL-Bausteinen dienen oder an TTL-(CMOS)- Eingänge größerer integrierter Systemschaltungen angepaßt werden müssen. ECL bedeutet Emittergekoppelte Logik, TTL Transistor-Transistorlogik und CMOS Complementary Metal Oxide Semiconductor. Der Pegel eines TTL-Ausgangs zwischen wenigstens 0,6V und 2,2V erfordert gegenüber dem Pegel eines ECL-Ausgangs zwischen -1,7V und -0,9V bzw. 3,3V und 4,1V immer einen zusätzlichen Schaltungsaufwand.

Aus der Zeitschrift "radio fernsehen elektronik", 37 (1988) 2, Seiten 124 und 129 ist bereits eine Pegelwandlung ECL-TTL und umgekehrt bekannt. Die gezeigten Bausteine erfordern einen erheblichen Zusatz zum Leistungsaufwand des Oszillators.

Der Erfindung liegt die Aufgabe zugrunde, eine Anordnung der einleitend geschilderten Art anzugeben, bei der entweder an den TTL-Pegel-Ausgang des ECL-TTL-Umsetzers integrierte CMOS-Schaltungen mit TTL-Pegel-Eingängen oder bei der an den ECL-Pegel-Ausgang integrierte ECL-Schaltungen oder integrierte CMOS-Schaltungen mit ECL-Pegel-Eingängen angeschlossen werden können.

Diese Aufgabe wird mit den Merkmalen des Patentanspruchs 1 gelöst. Ausgestaltungen der Erfindung sind den Unteransprüchen zu entnehmen.

Der Erfindung liegt die Erkenntnis zugrunde, daß die bei einem ECL-Pegel abgegebene Leistung ausreicht, um Eingänge von integrierten Schaltungen der Ausführung CMOS für hohe Frequenzen zu treiben. Ein TTL-Pegel erfordert Pegelwerte zwischen mindestens 0,6V und wenigstens 2,2V. Ein ECL-Pegel bei derselben einfachen Spannungsversorgung (+5V, Masse) muß zwischen mindestens 3,3V und wenigstens 4,1V liegen. TTL-Pegel lassen sich daher unmittelbar aus ECL-Pegeln ableiten. Erstere sind selbst bei sinusförmigen ECL-Signalen gewährleistet.

Vorteilhaft ist bei dieser Anordnung, daß eine Umstellung von ECL-Pegeln auf TTL-Pegel durch Nachrüstung mit dem ECL-TTL-Umsetzer ohne zusätzliche Leistungsaufnahme realisierbar ist. Außerdem kann die Leistung der Emitterfolgerstufe für die ECL-Anpassung optimal eingestellt werden, was mit einem ECL-Baustein anstelle der Emitterfolgerstufe nur begrenzt möglich ist. Die vom TTL-Ausgang benötigte Leistung für integrierte Schaltungen in CMOS-Ausführung für hohe Frequenzen und niedrige Eingangskapazitäten reicht aus.

Fig.1 zeigt eine erfindungsgemäße Anordnung,

Fig.2 zeigt die bekannten ECL- und TTL-Pegel,

Fig.3 zeigt ein erstes Pegeldiagramm zur Erläuterung der Anordnung nach Fig.1,

Fig.4 zeigt ein zweites Pegeldiagramm zur Erläuterung der Anordnung nach Fig.1 und

Fig.5 zeigt den erfindungsgemäßen ECL-TTL-Umsetzer detailliert.

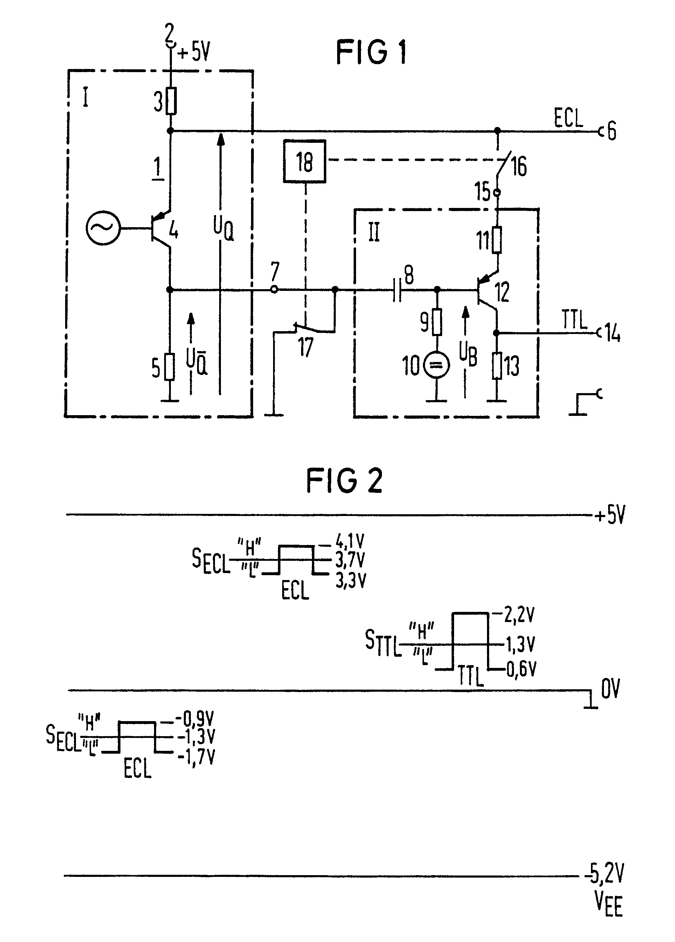

Fig.1 zeigt eine erfindungsgemäße Anordnung mit einem Oszillator I und einem ECL-TTL-Umsetzer II.

Der Oszillator 1 enthält ausgangsseitig eine Emitterfolgerstufe 1 mit einem +5V-Betriebsspannungsanschluß 2, mit einem Emitterwiderstand 3, mit einem pnp-Transistor 4, mit einem Kollektor widerstand 5, mit einem ECL-Pegel-Ausgang 6 und mit einem Kollektorausgang 7.

Der ECL-TTL-Umsetzer II besteht aus einem Kondensator 8, aus einem Basis-Vorwiderstand 9, aus einer Vorspannungsquelle 10, aus einem Emitterwiderstand 11, aus einem pnp-Transistor 12, aus einem Kollektorwiderstand 13 und aus einem TTL-Pegel-Ausgang 14. Weiter sind Schalter 15 und 16 und eine Schaltersteuerung 17 enthalten.

Fig.2 zeigt die bekannten ECL- und TTL-Pegel. Die ECL-Pegel können zwischen wenigstens -1,7V und -0,9V oder zwischen wenigstens 3,3V und 4,1V liegen, je nachdem wo die zugehörige Anordnung geerdet ist. Mit $S_{ECL}$ und $S_{TTL}$ sind Schaltschwellen bezeichnet, die logische Zustände "H" (high) und "L" (low) trennen.

Die Emitterfolgerstufe 1 ist derart dimensioniert, daß am Ausgang 6 eine Spannung $U_Q$ mit ECL-Pegeln zwischen wenigstens 3,3V und 4,1V gemäß Fig.2 mit der benötigten Ausgangsleistung auftritt. Am Kollektoranschluß 7 tritt dann eine demgegenüber invertierte Spannung $U_{\overline{Q}}$ auf, die ungefähr dieselbe Amplitude besitzt.

Der pnp-Transistor 12 im ECL-TTL-Umsetzer II wird von der Spannung $U_Q$ über den Emitterwiderstand 11 als Basis-Schaltung und von der Spannung $U_{\overline{Q}}$ über den Kondensator 8 als Emitter-Schaltung angesteuert. Es wird keine +5V-Betriebsspannung benötigt. Die Basis-Schaltung garantiert die benötigte Verstärkung, die Emitter-Schaltung sorgt für ein schnelles Ausschalten des Transistors 12.

Wird ein Verbraucher an den ECL-Pegel-Ausgang 6 angeschaltet, dann wird über die Schaltersteuerung 18 der Schalter 16 geöffnet und der Schalter 17 geschlossen. Wird ein Verbraucher jedoch an dem TTL-Pegel-Ausgang 14 angeschlossen, dann werden die Schalter 16 und 17 umgekehrt geschaltet. Die Schließung des Schalters 17 bewirkt ein Kurzschließen des Kollektorwiderstands 5.

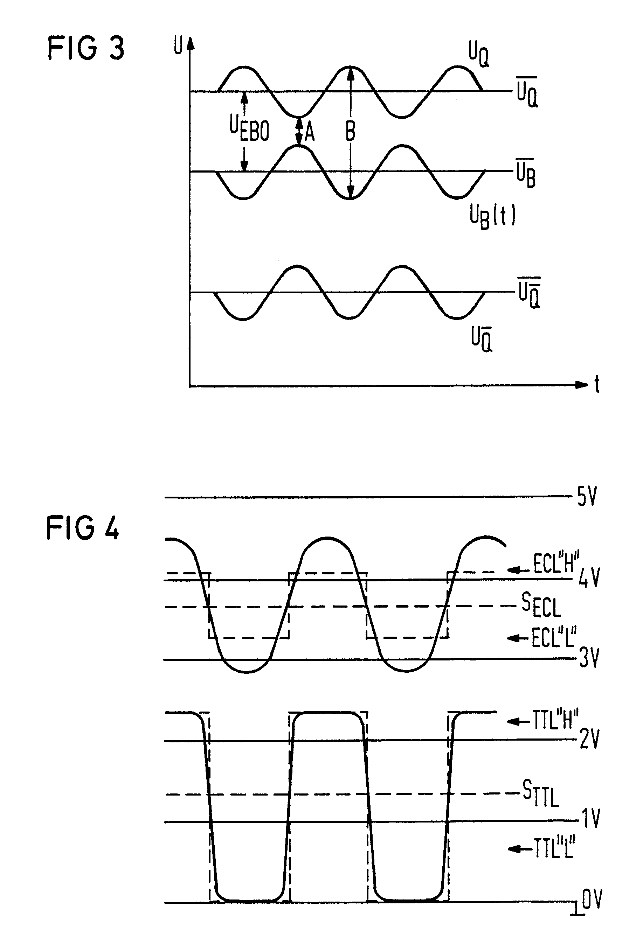

Fig.3 zeigt gegensinnige sinusförmige Spannungen $U_Q$ und $U_{\overline{Q}}$. Letztere wird durch die Vorspannung zur Basis-Spannung $U_B$ angehoben. Der Abstand zwischen der mittleren Spannung $\overline{U_Q}$ und der mittleren Spannung $\overline{U_B}$ ist die Emitter-Basis-Spannung $U_{EBO}$. Bei der Spannungsdifferenz A ist der Transistor 12 gesperrt und bei der Spannungsdifferenz B leitend.

Fig.4 zeigt nochmals die Spannung $U_Q$ am ECL-Pegel-Ausgang 6 und die aus dieser resultierende Spannung am TTL-Pegel-Ausgang 14 unter Berücksichtigung der "Signalverteilung" in der Spannungsebene.

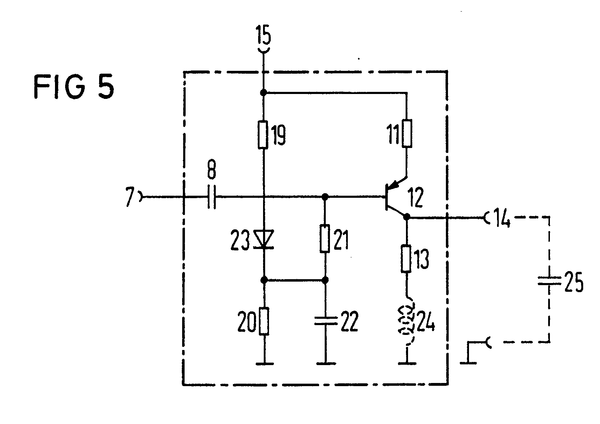

Fig.5 zeigt eine Variante des ECL-TTL-Umsetzers II bei der die Basis-Spannung $U_B$ mittels der Widerstände 19 bis 21 und des Kondensators 22 erzeugt wird. Die Diode 23 dient zur Temperaturkompensation.

Eine Drossel 24 kann zur Kompensation von Lastkapazitäten 25 dienen.

## Ansprüche

1. Anordnung mit einem Oszillator (I), der eine ausgangsseitige Emitterfolgerstufe (1) enthält, deren erster Emitterwiderstand (3) mit einem +5V-Betriebsspannungsanschluß (2) und deren Emitter mit einem ECL-Pegel-Ausgang (6) verbunden ist, und mit einem ECL-TTL-Umsetzer (II),
**dadurch gekennzeichnet,**
daß in der Emitterfolgerstufe (1) ein erster pnp-Transistor (4), ein mit Erde verbundener erster Kollektorwiderstand (5) und ein Kollektorausgang (7) vorgesehen sind und daß in dem ECL-TTL-Umsetzer (II) ein zweiter pnp-Transistor (12) vorgesehen ist, dessen zweiter Emitterwiderstand (11) mit dem ECL-Pegel-Ausgang (6), dessen zweiter Kollektorwiderstand (13) mit Erde, dessen Basis einerseits über einen Vorwiderstand (9) und eine Vorspannungsquelle (10) mit Erde und andererseits über einen ersten Kondensator (8) mit dem Kollektorausgang (7) des ersten pnp-Transisitors (4) und dessen Kollektor mit einem TTL-Pegel-Ausgang (14) verbunden ist.

2. Anordnung nach Anspruch 1,
**dadurch gekennzeichnet,**
daß zwischen dem zweiten Kollektorwiderstand (13) und Erde eine Drossel (24) vorgesehen ist.

3. Anordnung nach Anspruch 1 oder 2,
**dadurch gekennzeichnet,**
daß als Vorspannungsquelle (10) mit Vorwiderstand (9) zwischen dem ECL-Pegel-Ausgang (6) und Erde ein erster (19) und ein zweiter (20) Spannungsteilerwiderstand vorgesehen sind, deren Spannungsteilerabgriff einerseits über einen Basiswiderstand (21) mit der Basis des zweiten pnp-Transistors (12) und andererseits über einen zweiten Kondensator (22) mit Erde verbunden ist.

4. Anordnung nach Anspruch 3,
**dadurch gekennzeichnet,**
daß zwischen dem mit dem ECL-Pegel-Ausgang (6) verbundenen ersten Spannungsteilerwiderstand (19) und dem Spannungsteilerabgriff eine Diode (23) vorgesehen ist.

5. Anordnung nach Anspruch 1,
**dadurch gekennzeichnet,**
daß zwischen dem ECL-Pegel-Ausgang (6) und dem zweiten Emitterwiderstand (11) ein erster Schalter (16) vorgesehen ist, daß zwischen dem Kollektorausgang (7) des ersten pnp-Transistors (4) und Erde ein zweiter Schalter (17) vorgesehen ist und daß eine Schaltersteuerung (18) vorgesehen ist, die die Schalter (16, 17) gegensinnig öffnet und schließt.

6. Anordnung nach einem der vorhergehenden Ansprüche, **dadurch gekennzeichnet,**
daß der ECL-TTL-Umsetzer (II) als einsetzbares Modul ausgebildet ist.

EP 0 398 040 A2

# FIG 1

# FIG 2

FIG 3

FIG 4

FIG 5